# EUROPEAN PATENT APPLICATION

(11) **EP 4 213 194 A1**
(43) Date of publication of application: **19.07.2023**
(21) Application number: 22216882.5
(22) Date of filing: 28.12.2022
(51) Int. Cl.: H01L 21/8234, H01L 27/088, H01L 29/66, H01L 29/423, H01L 29/786, H10B 10/00

(54) **SEMICONDUCTOR DEVICE AND METHOD OF FABRICATING THE SAME**

(30) Priority: 03.01.2022 KR 20220000409
(71) Applicant: Samsung Electronics Co., Ltd., Gyeonggi-do 16677 (KR)
(72) Inventor: KANG, Myoungho, 16677 Suwon-si, Gyeonggi-do (KR); KIM, Yongah, 16677 Suwon-si, Gyeonggi-do (KR)
(74) Representative: Kuhnen & Wacker Patent- und Rechtsanwaltsbüro PartG mbB

(57) **Abstract**

A semiconductor device includes a first active fin (105A) having first fin-type patterns (105A1, 105A2) and a first separation region (SP1) therebetween; a second active fin (105B) having second fin-type patterns (105B1, 105B2) and a second separation region (SP2) therebetween, where a first trench region (T1) between the first and second active fins (105A, 105B) has a first depth (P1), and the first and second fin-type patterns (105A1, 105A2, 105B1, 105B2) are merged by the first trench region (T1); a third active fin (105C) adjacent to the first active fin (105A), where a second trench region (T2) between the first and third active fins (105A, 105B) has a second depth (P2) that is greater than the first depth (P1); and at least one first gate line (GL1) intersecting the first and second active fins (105A, 105B) and the third active fins (105C).

## Description

### FIELD

The present disclosure relates to a semiconductor device and a method of fabricating the same.

### BACKGROUND

A multigate transistor, in which a fin-type silicon body is formed on a substrate and a gate is formed on a surface of the silicon body, has been proposed as a scaling technique for increasing the density of semiconductor devices.

Since such multigate transistors use three-dimensional channels, they may be scaled. In addition, current control capability may be improved without increasing a gate length of such multigate transistors.

As a distance between the fins is reduced to decrease a cell area, an etching process using a mask may be performed a plurality of times for a process of cutting a fin. Therefore, the process has become complex and more difficult in decreasing a cell area.

### SUMMARY

Example embodiments provide a highly integrated semiconductor device.

Example embodiments provide a method of fabricating a highly integrated semiconductor device.

According to an example embodiment, a semiconductor device includes a first active fin extending in a first direction and having first fin-type patterns aligned with each other with a first separation region therebetween; a second active fin extending in the first direction and having second fin-type patterns aligned with each other with a second separation region therebetween, wherein the first and second separation regions are arranged to not overlap each other in a second direction that intersects the first direction, and wherein a first trench region between the first and second active fins has a first depth; a third active fin extending in the first direction adjacent to the first active fin, wherein a second trench region between the first and third active fins has a second depth that is greater than the first depth; a fourth active fin extending in the first direction adjacent to the second active fin, wherein a third trench region between the second and fourth active fins has a third depth that is greater than the first depth; at least one first gate line extending in the second direction and intersecting the first and second active fins and the third active fin; and at least one second gate line extending in the second direction and intersecting the first and second active fins and the fourth active fin. The first fin-type patterns and the second fin-type patterns are merged by the first trench region, and the second and third trench regions are connected to the first and second separation regions, respectively. A bottom of the first separation region is at a same level as a bottom of the second trench region, and a bottom of the second separation region is at a same level as a bottom of the third trench region.

According to an example embodiment, a semiconductor device includes a first active fin extending in a first direction and having first and second fin-type patterns separated by a separation region; a second active fin extending in the first direction and having a central region overlapping the separation region in a second direction that intersects the first direction, and first and second end regions overlapping the first and second fin-type patterns, respectively, in the second direction, wherein a first trench region defining opposing side surfaces of the first and second active fins has a first depth; a third active fin extending in the first direction and having one side surface opposing another side surface of the first active fin, wherein a second trench region defining the another side surface of the first active fin and the one side surface of the third active fin has a second depth that is greater than the first depth; a first gate line extending the second direction and intersecting the first fin-type pattern of the first active fin and a first portion of the second active fin; and a second gate line extending in the second direction and intersecting the second fin-type pattern of the first active fin and a second portion of the second active fin. The first and second fin-type patterns of the first active fin are merged with the second active fin by the first trench region. The second trench region is connected to the separation region, and a bottom of the separation region is at substantially a same level as a bottom of the second trench region

According to an example embodiment, a semiconductor device includes a first active fin extending in a first direction and having first fin-type patterns separated from each other by a first separation region; a second active fin extending in the first direction and having second fin-type patterns separated from each other by a second separation region, wherein the first and second separation regions overlap central regions of the second and first fin-type patterns, respectively, in a second direction that intersects the first direction, and the first and second fin-type patterns respectively overlap adjacent fin-type patterns, among the second and first fin-type patterns, in the second direction; a third active fin extending in the first direction adjacent to the first active fin; a fourth active fin extending in the first direction adjacent to the second active fin; a first trench region between the first and second active fins and having a first depth that is smaller than a depth of the first and second separation regions; a second trench region between the first and third active fins and having a second depth that is greater than the first depth; a third trench region between the second and fourth active fins and having a third depth that is greater than the first depth; first gate lines extending in the second direction and intersecting the third active fin and overlapping portions of the first and second fin-type patterns; and second gate lines extending in the second direction and intersecting the fourth active fin and the overlapping portions of the first and second fin-type patterns

According to an example embodiment, a method of fabricating a semiconductor device includes: forming a plurality of line patterns on a semiconductor substrate to extend in parallel to each other in a first direction, wherein the plurality of line patterns comprise first and second line patterns that are adjacent to each other, and a third line pattern on one side of the first line pattern; forming a hardmask on the semiconductor substrate and on the plurality of line patterns; performing a lithography process using a photomask on the hardmask to form a photoresist pattern; forming a mask pattern from the hardmask using the photoresist pattern, wherein the mask pattern comprises a first portion on the first and second line patterns, a second portion on the third line pattern, a first opening between the first portion and the second portion, and a second opening extending from the first opening to separate the first line pattern; and etching the semiconductor substrate using the mask pattern to form a plurality of active fins extending in the first direction.

### BRIEF DESCRIPTION OF DRAWINGS

The above and other aspects, features, and advantages of the present disclosure will be more clearly understood from the following detailed description, taken in conjunction with the accompanying drawings.
FIG. 1 is a layout view of a semiconductor device according to an example embodiment.
FIGS. 2A and 2B are cross-sectional views of the semiconductor device illustrated in FIG. 1, taken along lines 11-11' and 12-12', respectively.
FIG. 3 is a cross-sectional view of the semiconductor device illustrated in FIG. 1, taken along line II-II'.
FIGS. 4A and 4B are layout views of an SRAM cell of the semiconductor device illustrated in FIG. 1.
FIG. 5 is a circuit diagram of the SRAM cell illustrated in FIG. 4B.
FIG. 6 illustrates cross-sectional views of the SRAM cell illustrated in FIG. 4A, taken along lines A-A', B-B', and C-C'.
FIG. 7 is a cross-sectional view of the SRAM cell illustrated in FIG.4A, taken along line D-D'.
FIGS. 8 and 9 are cross-sectional views of a semiconductor device according to an example embodiment.
FIGS. 10A, 10B, 11A, 11B, 12A, 12B, 13A, 13B, 13C, 14A, 14B, 14C, 15A, 15B, 15C, 16A, 16B, 16C, 17A, 17B, and 17C, illustrate a method of fabricating a semiconductor device according to an example embodiment. FIGS. 10A to 16A are plan views for each main process, illustrating a method of fabricating a semiconductor device according to an example embodiment. FIGS. 13B to 17B are cross-sectional views of FIGS. 13A to 17A, respectively taken along line 11-11', and FIGS. 13C to 17C are cross-sectional views of FIGS. 13A to 17A, respectively taken along line 12-12'.
FIG. 18 is a plan illustrating a photomask applied to a process of FIGS. 12A and 12B.
FIGS. 19A and 19B are schematic plan views illustrating an optical proximity correction process for designing a notch region, as partially enlarged views of portion "C1" of FIG. 18.
FIG. 20A is a cross-sectional view of FIG. 15A, taken along line II-II', and FIG. 20B is a partially enlarged view of portion "C2" of FIG. 15A.

### DETAILED DESCRIPTION

Hereinafter, example embodiments will be described with reference to the accompanying drawings. The terms first, second, third, etc. may be used herein merely to distinguish one element or direction from another. Relative terms such as "below" or "above" or "upper" or "lower" or "top" or "bottom" or "horizontal" or "lateral" or "vertical" may be used herein to describe a relationship of one element, layer or region to another element, layer or region as illustrated in the figures. It will be understood that these terms are intended to encompass different orientations of the device in addition to the orientation depicted in the figures.

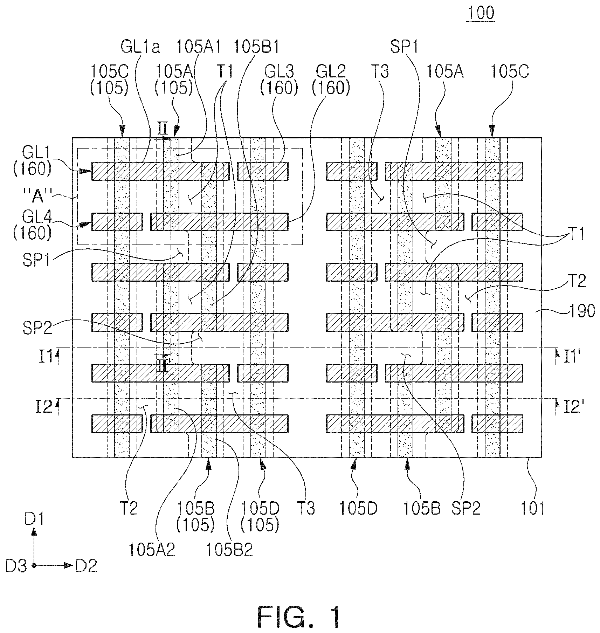

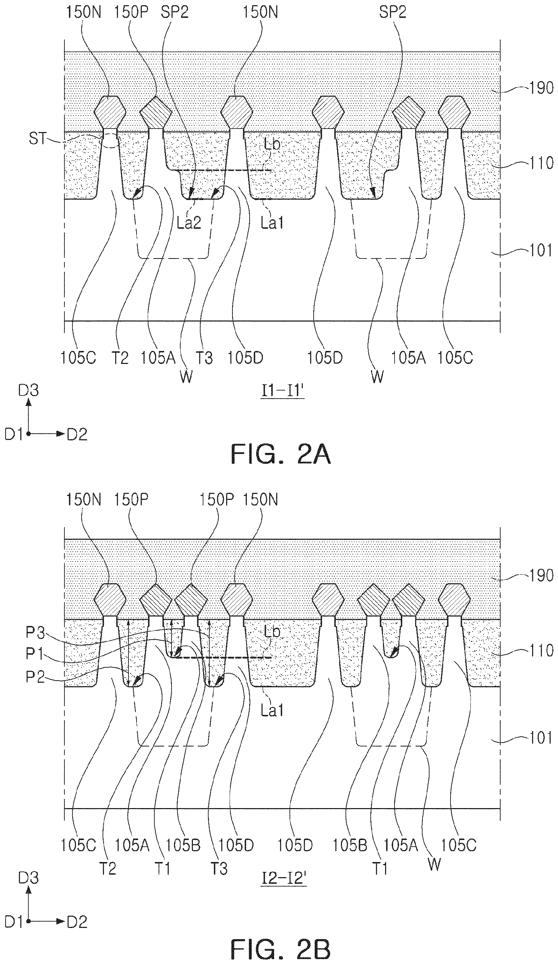

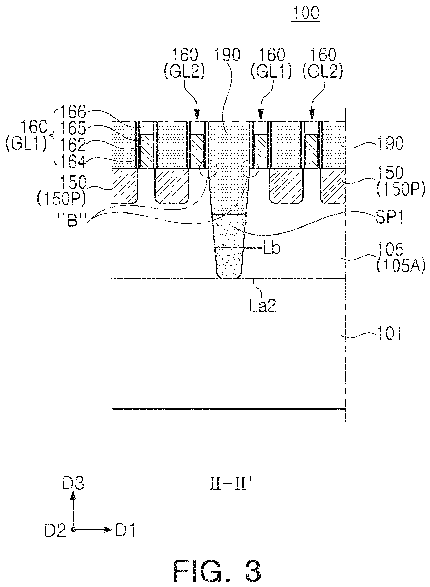

FIG. 1 is a layout view of a semiconductor device according to an example embodiment, FIGS. 2A and 2B are cross-sectional views of the semiconductor device illustrated in FIG. 1, taken along lines 11-11' and 12-12', respectively, and FIG. 3 is a cross-sectional view of the semiconductor device illustrated in FIG. 1, taken along line 11-11'.

Referring to FIGS. 1 to 3, a semiconductor device 100 according to the present example embodiment may include a substrate 101, a plurality of active fins 105 protruding from the substrate 101 and extending in a first direction (for example, D1), and a gate line 160 intersecting the plurality of active fins 105 and extending in a second direction (for example, D2).

The semiconductor device 100 may have first to fourth active fins 105A, 105B, 105C, and 105D disposed to be mirror-symmetrical with respect to left and right regions of the semiconductor device 100. For example, as illustrated in FIGS. 2A and 2B, the first to fourth active fins 105A, 105B, 105C, and 105D may have a structure protruding in a third direction (for example, D3), substantially perpendicular to an upper surface of the substrate 101. For example, the substrate 101 may be a semiconductor substrate such as a silicon substrate or a germanium substrate, or a silicon-on-insulator (SOI) substrate.

The device isolation layer 110 may define first to fourth active fins 105A, 105B, 105C, and 105D. As illustrated in FIGS. 2A and 2B, the device isolation layer 110 may be disposed on the substrate 101 to cover side surfaces of the first to fourth active fins 105A, 105B, 105C, and 105D of the substrate 101. The device isolation layer 110 may include, for example, an oxide layer, a nitride layer, or a combination thereof. In some embodiments, the device isolation layer 110 may be a shallow trench isolation (STI) region defining the first to fourth active fins 105A, 105B, 105C, and 105D.

The semiconductor device 100 according to the present embodiment may not include a deep trench isolation (DTI) region, deeper than the STI region, because the first to fourth active fins 105A, 105B, 105C, and 105D may be formed by performing a mask process (for example, an EUV process) once. The device isolation layer 110 may be formed to expose upper regions of the first to fourth active fins 105A, 105B, 105C, and 105D. In some embodiments, the isolation layer 110 may have a curved upper surface having a level becoming higher or rising in a direction toward the first to fourth active fins 105A, 105B, 105C, and 105D.

Referring to FIGS. 1, 2A, and 2B, the first and second active fins 105A and 105B may be disposed adjacent to each other to extend in a first direction (for example, D1). The first and second active fins 105A and 105B adjacent to each other may be disposed between the third and fourth active fins 105C and 105D. For example, the third active fin 105C and the fourth active fin 105D may be disposed to be adjacent to the first active fin 105A and the second active fin 105B, respectively. A distance between the first and second active fins 105A and 105B may be smaller than a distance between the first and third active fins 105A and 105C and/or a distance between the second and fourth active fins 105B and 105D. The distance between the first and third active fins 105A and 105C may be substantially the same as the distance between the second and fourth active fins 105B and 105D.

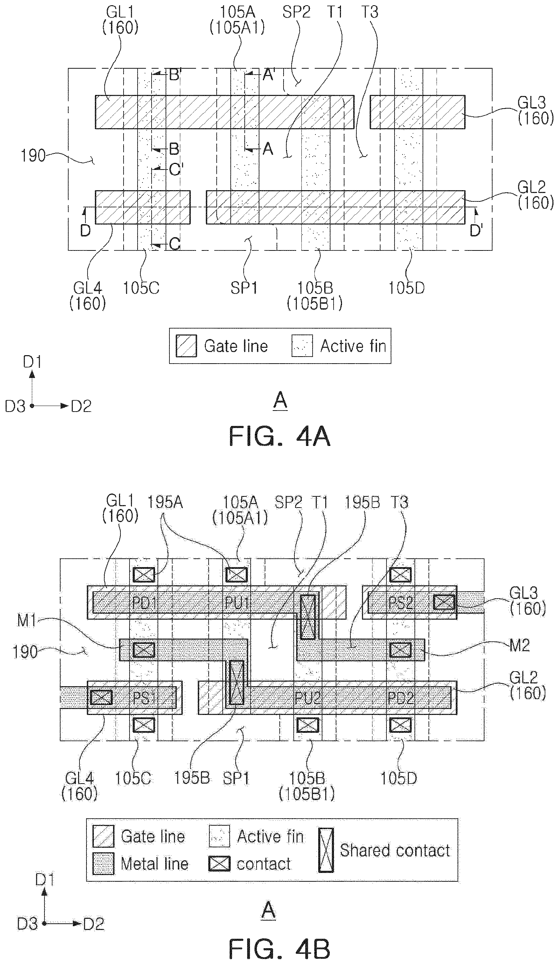

Each active fin 105A, 105B, 105C, 105D may constitute one or more fin field effect transistors (FinFETs). In the present embodiment, each of the active fins 105A, 105B, 105C, and 105D may constitute fin field effect transistors constituting the SRAM (see FIG. 4B). As described above, the semiconductor device 100 illustrated in FIG. 1 may be six SRAM cell arrays in which SRAM unit cells denoted by "A" are arranged in a 2-by-3 array.

In the present embodiment, the substrate 101 may have an active region having first conductivity type (for example, P-type), and may include a well W having second conductivity type (for example, N-type), different from the first conductivity type. The first and second active fins 105A and 105B may be second-conductivity-type (for example, N-type) active fins for constituting a first-conductivity-type (for example, P-type) transistor, and the third and fourth active fins 105C and 105D may be first-conductivity-type (for example, P-type) active fins for constituting a second-conductivity-type (for example, N-type) transistor.

Referring to FIGS. 1 and 2B, the first active fin 105A may include a plurality of (for example, two) first fin-type patterns 105A1 and 105A2 with a first separation region (also referred to as a "first notch region") interposed therebetween, and the second active fin 105B may include a plurality of (for example, two) second fin-type patterns 105B1 and 105B2 with a second separation region SP2 (also referred to as a "second notch region") interposed therebetween. The plurality of first fin-type patterns 105A1 and 105A2 and the plurality of second fin-type patterns 105B1 and 105B2 may be each aligned on the same line.

A first trench region T1 having a first depth P1 may be formed between the first and second active fins 105A and 105B. The first trench region T1 may define opposing side surfaces of the first and second active fins 105A and 105B. Second and third trench regions T2 and T3 may be formed between the first and third active fins 105A and 105C and between the second and fourth active fins 105B and 105D, respectively. The second trench region T2 may define opposing side surfaces of the first and third active fins 105A and 105C, and the third trench region T3 may define opposing side surfaces of the second and fourth active fins 105B and 105D. A second depth P2 of the second trench region T2 and a third depth P3 of the third trench region T3 may be greater than the first depth P1.

As illustrated in FIG. 2B, the first and second active fins 105A and 105B may be merged by a first trench region T1. As used herein, fins that are "merged" may refer to fins that are separated by trenches having a smaller depth than that of separation regions or notch regions as described herein, such that the merged fins collectively protrude relative to the surfaces of the separation regions or notch regions. For example, lower regions of the plurality of first fin-type patterns 105A1 and lower regions of the plurality of second fin-type patterns 105A2 may be merged with each other by the first trench region T1 having a relatively small depth, such that the first fin-type patterns 105A1 and the second fin-type patterns 105A2 with the first trench region T1 therebetween collectively define a merged structure that protrudes relative to bottom surfaces of the separation regions SP1 and SP2 or the trench regions T2 and T3.

The first and second separation regions SP1 and SP2 may be a structure extending to a notch region to separate the first and second active fins 105A and 105B from the second and third trench regions T2 and T3, respectively. Each of the first and second separation regions SP1 and SP2 may have a depth, greater than the first depth P1 of the first trench region T1. As illustrated in FIG. 3, a bottom of the first separation region SP1 may have a level La2, substantially the same as a bottom level La1 of the second trench region T2. Similarly, a bottom of the second separation region SP2 may have a level, substantially the same as a bottom level of the third trench region T3. "Levels" as used herein may refer to relative depths or distances from a reference surface, for example, a surface of the substrate 101.

In the present embodiment, the first trench region T1 may have a portion TE extending to the first and second separation regions SP1 and SP2 in the first direction (for example, D1). Referring to FIGS. 2A and 3, the extending portion TE may have a level, higher than a bottom level La2 of the first and second separation regions and the bottom level La1 of the second and third trench regions T2 and T3. A top level Lb of the extending portion TE may be substantially equal to or slightly lower than a bottom level of the first trench region T1.

Referring to FIG. 1, in plan view, the first and second separation regions SP1 and SP2 may be arranged so as not to overlap in or when viewed along the second direction (for example, D2). In the present embodiment, each of the plurality of first fin-type patterns 105A1 and 105A2 may have a central region, overlapping the second separation region SP2 in the second direction (for example, D2) and end regions on opposite sides, respectively overlapping two adjacent second fin-type patterns 105B1 and 105B2 in the second direction (for example, D2). Similarly, the plurality of second fin-type patterns 105B1 and 105B2 may have a central region, overlapping the first separation region SP1 in the second direction (for example, D2), and end regions on opposite sides, respectively overlapping two adjacent first fin-type patterns 105A1 and 105A2. In the present example embodiment, the plurality of first and second fin-type patterns 105A1, 105A2, 105B1, and 105B2 may have the same length, but example embodiments are not limited thereto. A length or dimension of the overlapping portion in the second direction (for example, the portion that overlaps along direction D2) may be designed or configured to be greater than a width or dimension of the first and second separation regions SP1 and SP2 in the first direction (for example, the width along direction D1),

The semiconductor device 100 according to the present embodiment may include a plurality of gate lines GL1, GL2, GL3, and GL4 extending in the second direction (for example, D2) and disposed to intersect at least one of the active fins 105.

Referring to FIG. 3, the gate lines GL1, GL2, GL3, and GL4 may include a gate dielectric layer 162, a gate electrode 165, gate spacers 164, and a gate capping layer 166.

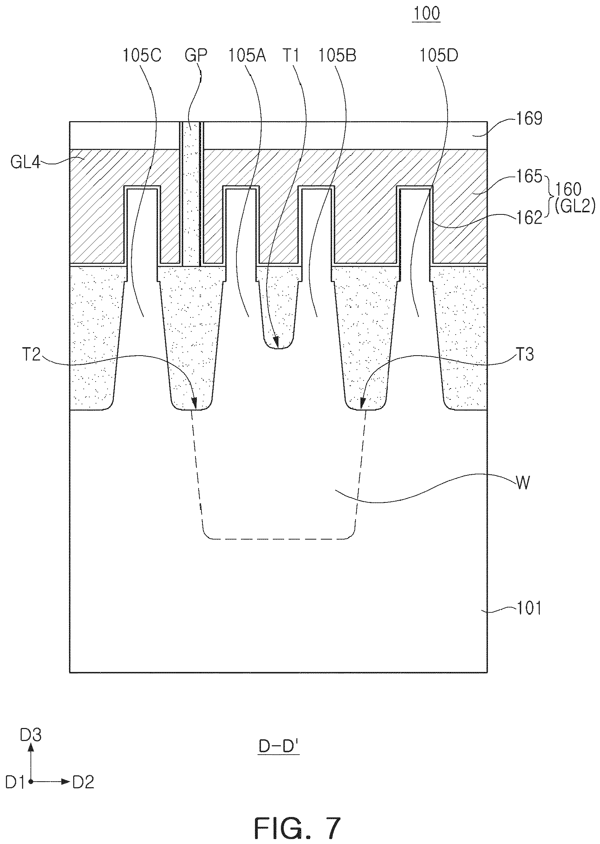

The gate dielectric layer 162 may be disposed between the active fin 105 and the gate electrode 165 and between the channel structure 140 and the gate electrode 165, as illustrated in FIGS. 3 and 7. The gate dielectric layer 162 may be formed to surround the channel layers 141, 142, 143, and 144 in the second direction (for example, D2), and may extend from an upper surface of the fin-type active region 105 to an upper surface of the device isolation layer 110 (see FIG. 7). As illustrated in FIG. 3, the gate dielectric layer 162 may extend between the gate electrode 165 and the gate spacers 164. For example, the gate dielectric layer 162 may include an oxide, a nitride, or a high-κ material. The high-κ material may refer to a dielectric material having a dielectric constant, higher than that of a silicon oxide layer (SiO₂). The high dielectric constant material may be at least one of, for example, aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), or praseodymium oxide (Pr₂O₃).

The gate electrode 165 may include a conductive material, for example, a metal nitride such as titanium nitride (TiN), tantalum nitride (TaN), or tungsten nitride (WN), and/or a metal such as aluminum (Al), tungsten (W), or molybdenum (Mo), or a semiconductor material such as doped polysilicon. In some embodiments, the gate electrode 165 may have a multilayer structure including two or more layers. In some embodiments, the gate electrode 165 may be disposed between adjacent transistors, and the gate electrode 165 may be separated by an additional separation portion ("GP" of FIG. 7) disposed between adjacent transistors.

Gate spacers 164 may be disposed on opposite side surfaces of the gate electrode 165. In some embodiments, the gate spacers 164 may have a multilayer structure. For example, the gate spacers 164 may include an oxide, a nitride, or an oxynitride, or, for example, a low-κ dielectric.

The gate capping layer 166 may be disposed on the gate electrode 165, and a lower surface and side surfaces thereof may be surrounded by the gate electrode 165 and the gate spacer layers 164, respectively. For example, the gate capping layer 166 may include an oxide, a nitride, or an oxynitride.

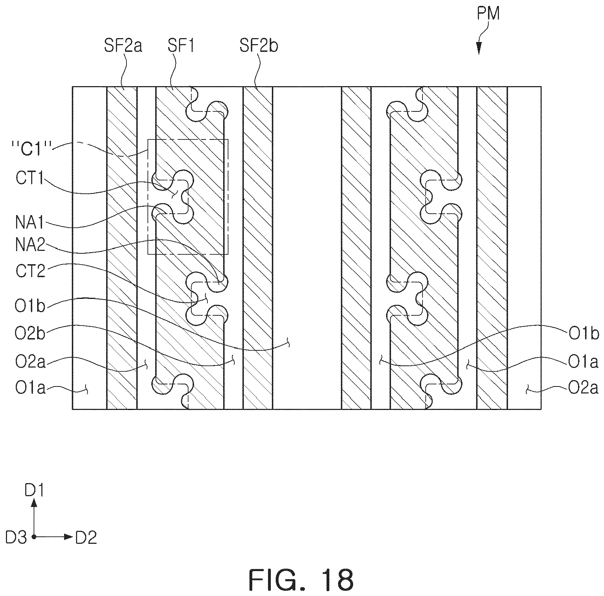

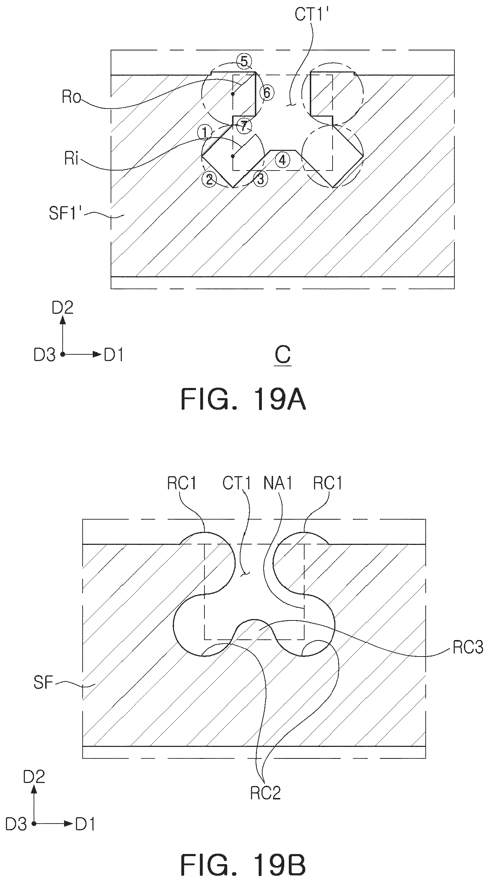

As denoted by "B" of FIG. 3, one side surface of each of the second and third gate lines may be aligned to substantially match cross-sections of the first and second fin-type patterns provided by the first separation region. Such an alignment may be obtained by designing a notch region (for example, a region corresponding to the separation region) of a mask using a hexagonal-corner rounding (H-CR) optical proximity correction (OPC) method, a type of OPC method, to significantly reduce distortion occurring during an EUV process (See FIGS. 18, 19A, and 19B).

As illustrated in FIG. 3, the active fins 105 may be partially recessed on opposite sides of the gate lines, and source/drain regions 150 may be disposed on the recessed active fins 105.

The source/drain regions 150 may be disposed on regions, in which the active fins 105 are recessed, on opposite sides of the gate lines GL1, GL2, GL3, and GL4. In the present embodiment, the source/drain region 150 may have an upper surface having a level, higher than a level of an upper surface of the active fin 105, by forming a recess in a region of the active fin 105 and performing selective epitaxial growth (SEG) on the recess. The source/drain regions 150 may be provided as a source region or a drain region of the fin field effect transistors (FinFET). Upper surfaces of the source/drain regions 150 may be disposed on a level the same as or similar to a level of lower surfaces of the gate lines GL1, GL2, GL3, and GL4 in the cross-section illustrated in FIG. 3. In another embodiment, relative heights of the source/drain regions 150 and the gate lines GL1, GL2, GL3, and GL4 may vary.

The source/drain regions 150 may include an epitaxial layer including impurities. For example, the active fins 105 may include impurities diffused from the source/drain regions 120 in a region in contact with the source/drain regions 150.

The cross-sections according to FIGS. 2A and 2B may include first and second source/drain regions 150P and 150N having different shapes. In the present embodiment, the first source/drain region 150P associated with the first and second active fins 105A and 105B may include a silicon-germanium (SiGe) epitaxial. As illustrated in FIGS. 2A and 2B, the cross-section of the first source/drain region 150A may have a slightly angular polygonal shape, for example, a pentagonal shape. In some embodiments, silicon-germanium (SiGe) epitaxial growth may generate compressive stress in the first and second active fins 105A and 105B, silicon (Si), for example, to improve electrical characteristics. In the present embodiment, P-type impurities may be doped into the first source/drain region 150P in-situ or by an implantation process. For example, the P-type impurity may include boron (B), indium (In), and/or gallium (Ga). Since the first and second active fins 105A and 105B are relatively close to each other, the first source/drain regions 150A grown from the first and second active fins 105A and 105B may have a structure in which they are merged with each other.

In addition, the second source/drain regions 150N associated with the third and fourth active fins 105C and 105D may include a silicon (Si) epitaxial layer. A cross-section of the second source/drain region 150N may have a gentle hexagonal shape. The second source/drain regions 150N may be doped with N-type impurities in a manner similar to that of the first source/drain regions 150P. For example, the N-type impurities include phosphorus (P), nitrogen (N), arsenic (As), and/or antimony (Sb).

An interlayer insulating layer 190 may be disposed to cover the source/drain regions 150 and the gate lines GL1, GL2, GL3, and GL4. The interlayer insulating layer 190 may include at least one of, for example, an oxide, a nitride, or an oxynitride, or may include a low-κ dielectric. Contacts (195A and 195B of FIG. 4B) may penetrate through the interlayer insulating layer 190 to be connected to the first and second source/drain regions 150P and 150N or may penetrate through the gate capping layer 166 to be connected to the gate electrode 165, and may apply an electrical signal to the first and second source/drain regions 150P and 150N and the gate electrode 165. The contacts 195A and 195B may be disposed to recess the source/drain regions 150P and 150N by a predetermined depth, but example embodiments are not limited thereto. However, the contacts 195A and 195B may include a conductive barrier and a contact plug. For example, the contact plug may include a metal such as tungsten (W), aluminum (Al), or copper (Cu), or a semiconductor material such as doped polysilicon.

As described above, each of the active fins 105A, 105B, 105C, and 105D may be coupled to the gate lines GL1, GL2, GL3, GL4 and the source/drain 150 to constitute a fin field effect transistor (FinFET). As described above, such a fin field effect transistor (FinFET) may be provided as transistors constituting an SRAM

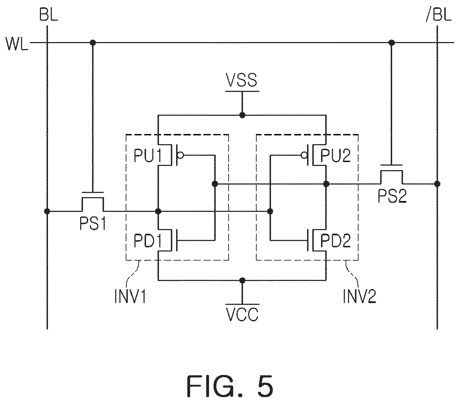

Hereinafter, the SRAM cell of the semiconductor device according to the present embodiment will be described in detail with reference to FIGS. 4A and 4B and FIG. 5.

FIG. 4A illustrates a layout of active fins and gate lines of an SRAM cell corresponding to region "A" of the semiconductor device 100 of FIG. 1.

Referring to FIG. 4A, the first and second fin-type patterns 105A1 and 105B1 may have a portion overlapping each other in the second direction (for example, D2). The first and second separation regions SP1 and SP2 may be respectively disposed in end portions of the other sides of the first and second fin-type patterns 105A1 and 105B1, and may be arranged so as not to partially overlap each other. A length of the portion overlapping each other in the second direction (for example, D2) may be greater than a width of the first and second separation regions SP1 and SP2 in the first direction (for example, D1).

A first gate line GL1 may extend in a second direction (for example, D2) to be disposed to intersect the third active fin 105C and the overlapping portions. Similarly, a second gate line GL2 may be disposed to intersect the fourth active fin 105D and the overlapping portions. A third gate line GL3 may extend in the second direction (for example, D2) to be disposed to intersect the fourth active fin 105D. The fourth gate line GL4 may extend in the second direction (for example, D2) to be disposed to intersect the third active fin 105C. The third and fourth gate lines GL3 and GL4 may be disposed on the same line as the first and second gate lines GL1 and GL2, respectively. In some embodiments, the first and second gate lines GL1 and GL2 and the third and fourth gate lines GL3 and GL4 may be understood as a structure obtained by respectively forming the same gate line (or dummy gate line) and then separating the gate line from a gate separation portion ("GP" of FIG. 7).

As illustrated in FIG. 4B, a desired SRAM cell may be configured by forming contacts 195A and 195B and metal lines M1, M2, M3, and M4 based on the layout of the active fins and the gate lines illustrated in FIG. 4A.

Referring to FIGS. 4B and 5, the SRAM cell employed in the present embodiment may include a pair of inverters INV1 and INV2, connected between a power supply node Vcc and a ground node Vss in series, and a first pass transistor PS1 and a second pass transistor PS2 connected to an output node of each of the inverters INV1 and INV2. Each of the first pass transistor PS1 and the second pass transistor PS2 may be connected to a bitline BL and a complementary bitline BL/. Gates of the first pass transistor PS1 and the second pass transistor PS2 may be connected to a wordline WL

The first inverter INV1 may include a first pull-up transistor PU1 and a first pull-down transistor PD1 connected in series, and the second inverter INV2 may include a second pull-up transistor PU2 and a second pull-down transistor PD2 connected in series. The first pull-up transistor PU1 and the second pull-up transistor PU2 may be PMOS transistors, and the first pull-down transistor PD1 and the second pull-down transistor PD2 may be NMOS transistors.

The first inverter INV1 and the second inverter INV2 may constitute a single latch circuit. To this end, an input node of the first inverter INV1 may be connected to an output node of the second inverter INV2, and an input node of the second inverter INV2 may be connected to an output node of the first inverter INV1.

Referring to FIG. 4B, the first pull-up transistor PU1 may be defined by a region, in which the first gate line GL1 and the first fin-type pattern 105A1 intersect each other, and a neighboring region thereof, and the first pull-down transistor PD1 may be defined by a region, in which the first gate line GL1 and the third active fin 105C intersect each other and a neighboring region thereof, and the first pass transistor PS1 may be defined by a region, in which the fourth gate line GL4 and the third active fin 105C intersect each other, and a neighboring region thereof. Similarly, the second pull-up transistor PU2 may be defined by a region, in which the second gate line GL2 and the second fin-type pattern 105B1 intersect each other, and a neighboring region thereof, and the second pull-down transistor PD2 may be defined by a region, in which the gate line GL2 and the fourth active fin 105D intersect each other, and a neighboring region thereof, and the second pass transistor PS2 may be defined by a region, in which the third gate line GL3 and the fourth active fin 105D intersect each other, and a neighboring region thereof.

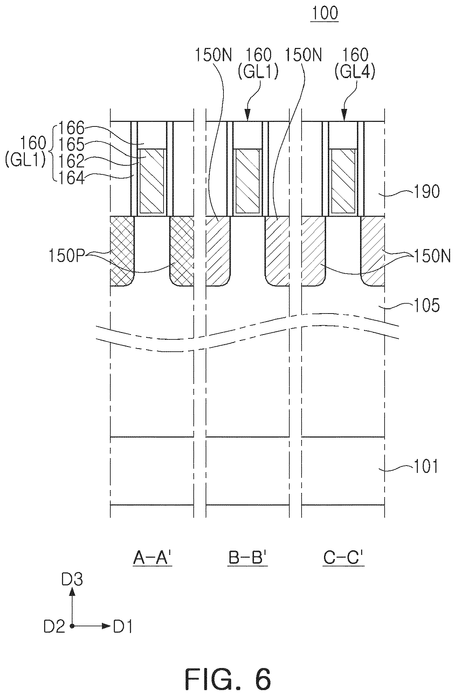

Although not clearly illustrated in FIG. 4B, source/drain 150 of FIG. 6 may be formed on both sides of a region in which the first to fourth gate lines GL1, GL2, GL3, and GL4 and the active fins (including the first and second fin-type patterns) intersect each other. A contact 195A may be formed on the source/drain 150. Not only the contact 195A, but also a shared contact 195B may be formed. The shared contact 195B may simultaneously connect the first fin-type pattern 105A1 and the second gate line GL2, and may be connected to the third active fin 105C by a first metal line M1. Similarly, the other shared contact 195B may simultaneously connect the second fin-type pattern 105B1 and the first gate line GL1, and may be connected to the fourth active fin 105D by a second metal line M2. Thus, a SRAM circuit structure illustrated in FIG. 5 may be implemented. In the present embodiment, each of the first and second pull-up transistors PU1 and PU2 may be a P-type MOSFET, and each of the first and second pull-down transistors PD1 and PD2 and the first and second pass transistors PS1 and PS2 may be an N-type MOSFET.

FIG. 6 illustrates cross-sectional views of the SRAM cell illustrated in FIG. 4A, respectively taken along lines A-A', B-B', and C-C'.

FIG. 6 illustrates cross-sectional views of the SRAM cell illustrated in FIG. 4A, respectively taken along lines A-A', B-B', and C-C', and FIG. 7 is a cross-sectional view of the SRAM cell illustrated in FIG. 2A, taken along line D-D'.

Referring to FIG. 6, cross-sections taken along lines A-A', B-B', and C-C' are cross-sections of the first pull-up transistor PU1, the first pull-down transistor PD1, and the first pass transistor PS1, respectively.

As described above, each of the first and second pull-up transistors PU1 and PU2 may be a P-type MOSFET, and each of the first and second pull-down transistors PD1 and PD2 and the first and second pass transistors PS1 and PS2 may be an N-type MOSFET.

In the substrate 101, the first and second active fins 105A and 105B may be N-type fins, and the third and fourth active fins 105C and 105D may be P-type fins. First source/drain regions 150P of the first and second active fins 105A and 105B, constituting the first pull-up transistor PU1, may be formed by re-growing a silicon-germanium (SiGe) epitaxial layer having a relatively high lattice constant. In the selectively and epitaxially grown SiGe layer, the content of Ge may vary depending on a growth direction. As described above, the first source/drain region 150P may have a pentagonal cross-section (see FIGS. 2A and 2B).

The source/drain regions 150N of the first and second pull-down transistors PD1 and PD2 and the first and second pass transistors PS1 and PS2 may be formed by re-growing a Si or SiC epitaxial layer having a relatively low lattice constant. As described above, the second source/drain region 150N may have a hexagonal shape or a polygonal cross-section having a gentle angle (see FIGS. 2A and 2B).

Although not illustrated, cross-sections of the second pull-up transistor PU2, the second pull-down transistor PD2, and the second pass transistor PS2 may also be understood to have structures, similar to those of the cross-sections illustrated in FIG. 6.

Referring to FIG. 7, second and fourth gate lines GL2 and GL4 disposed on the same line are illustrated. The gate lines may be formed along surfaces of the first to fourth active fins and the upper surface of the device isolation layer. As described above, the second and fourth gate lines GL2 and GL4 may have a structure obtained by forming the same gate line (or dummy gate line) and then separating the gate line (or dummy gate line) from a gate separation portion GP.

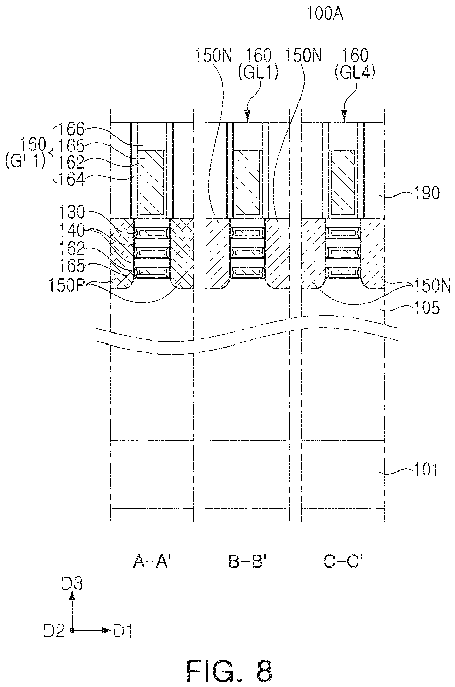

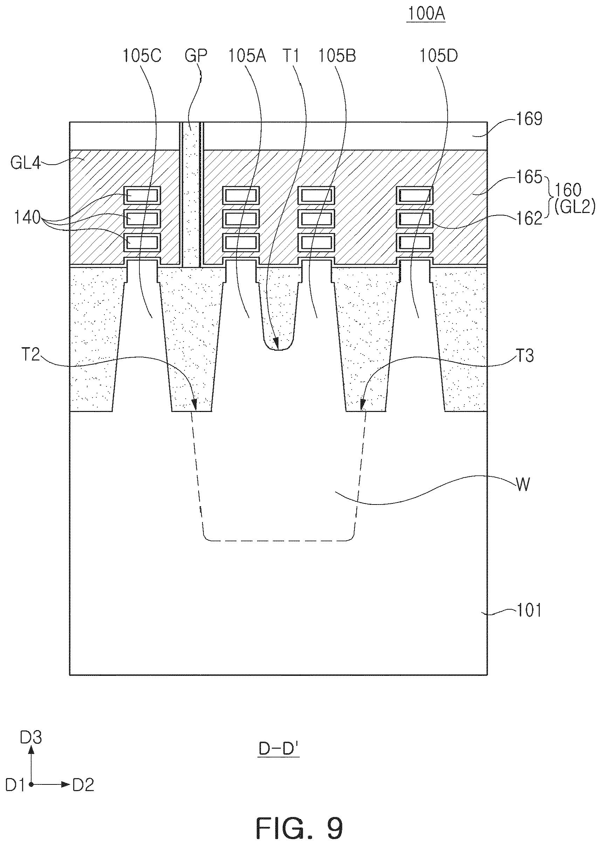

The semiconductor device 100 according to the present embodiment may be applied to transistors having various structures. As an example, the semiconductor device 100A illustrated in FIGS. 8 and 9 may have a transistor (for example, MBCFET^{®}) structure including nanosheets. FIGS. 8 and 9 are cross-sectional views of a semiconductor device according to an example embodiment, respectively, and may be understood as cross-sections corresponding to FIGS. 6 and 7.

Referring to FIGS. 8 and 9, a semiconductor device 100A according to the present embodiment may be understood to be similar to the semiconductor device 100 illustrated in FIGS. 1 to 7, except that an active pattern has a single structure in each transistor region and an active structure for a transistor is configured to include a plurality of nanosheets. In addition, components in the present embodiment may be understood with reference to descriptions of the same or similar components of the semiconductor device 100 illustrated in FIGS. 1 to 7, unless otherwise specified.

Referring to FIGS. 8 and 9, the semiconductor device 100A according to the present embodiment may include an active fin 105 for a transistor. Similarly to the previous embodiment, the active fin 105 may have a structure protruding from an upper surface of the substrate 101 in a third direction (for example, D3) and extending in a first direction (for example, D1).

The semiconductor device 100A according to the present example embodiment may further include a plurality of nanosheet-shaped channel layers 140, disposed to be vertically spaced apart from each other on active fins 105 (105A, 105B, 105C, and 105D of FIG. 9), and a plurality of internal spacers 130 disposed side by side with a gate electrode 1165 between the plurality of channel layers 140. The semiconductor device 100A may further include transistors having a gate-all-around type structure in which the disposed between the gate electrode 165 is disposed between the active fin 105 and lowermost channel layers 140 and between the plurality of channel layers 140. For example, each transistor of the semiconductor device 100A may include channel layers 140, source/drain regions 150P and 150N, and a gate electrode 165.

The plurality of channel layers 140 may include two or more channel layers disposed on the active fin 105 to be spaced apart from each other in a third direction (for example, D3). The channel layers 140 may be spaced apart from upper surfaces of the active fin 105 while being connected to the source/drain regions 150. Each of the channel layers 140 may have a width the same as or similar to a width of the active fin 105 in the second direction (for example, D2), and may have a width the same as or similar to a width of each of the gate lines GL1, GL2, and G4 in the first direction (for example, D1). However, as described in the present embodiment, when an internal spacer 130 is employed, each of the channel layers 140 may have a width less than that of each side surface below the gate line GL.

The plurality of channel layers 140 may be formed of a semiconductor material, and may include at least one of, for example, silicon (Si), silicon germanium (SiGe), or germanium (Ge). The channel layers 140 may be formed of, for example, the same material as the substrate 101 (for example, the active region). The number and shape of the channel layers 140, constituting a single channel structure, may vary according to example embodiments.

The internal spacers 130 may be disposed on opposite side surfaces of the gate electrode layer 165 between the plurality of channel layers 140 in the first direction. The gate electrode 165 may be electrically separated from the source/drain regions 150P and 150N by the internal spacers 130. The internal spacers 130 may have a planar side surface facing the gate electrode 165 or a cross-section convexly rounded toward the gate electrode 165 (see FIG. 8). The internal spacers 130 may be formed of an oxide, a nitride, or an oxynitride, for example, a low-κ dielectric.

As described above, the semiconductor device according to the present embodiment may be applied to transistors having various structures. In addition to the above-described embodiments, the semiconductor device may be implemented as a semiconductor device including a vertical FET (VFET) having an active region extending in a direction that is substantially perpendicular to the upper surface of the substrate 101, and a gate structure surrounding the semiconductor device, or a semiconductor device including a negative capacitance FET (NCFET) using a gate insulating layer having ferroelectric properties.

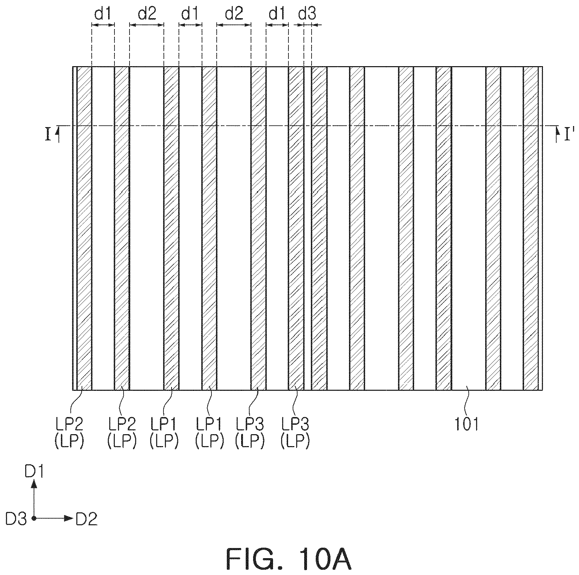

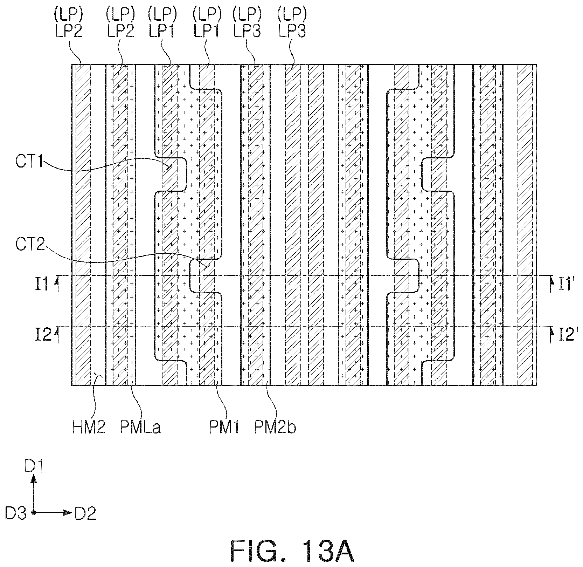

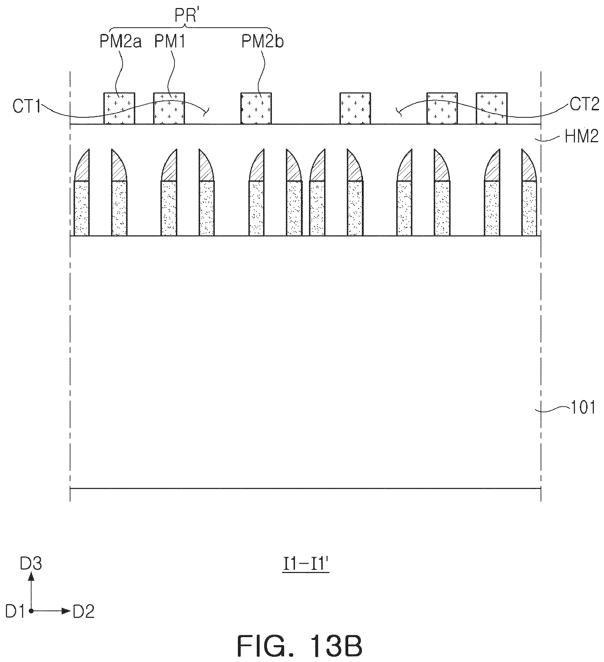

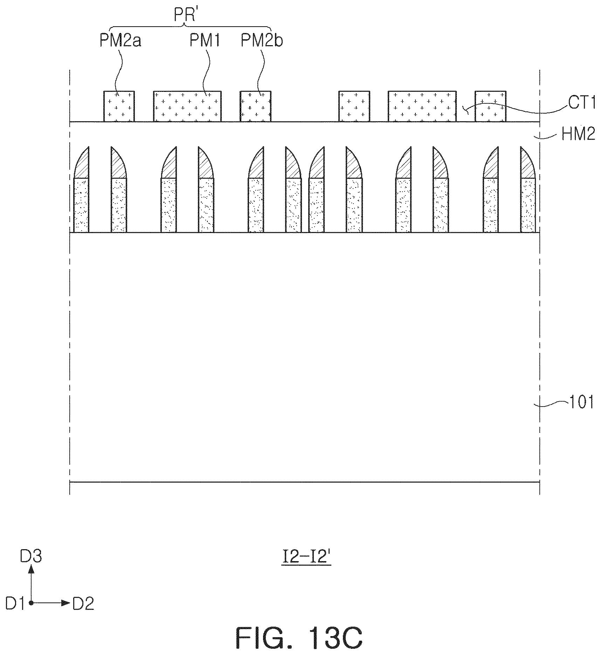

FIGS. 10A to 16A are plan views for each main process, illustrating a method of fabricating a semiconductor device according to an example embodiment. FIGS. 13B to 17B are cross-sectional views of FIGS. 13A to 17A, respectively taken along line 11-11', and FIGS. 13C to 17C are cross-sectional views of FIGS. 13A to 17A, respectively taken along line 12-12'.

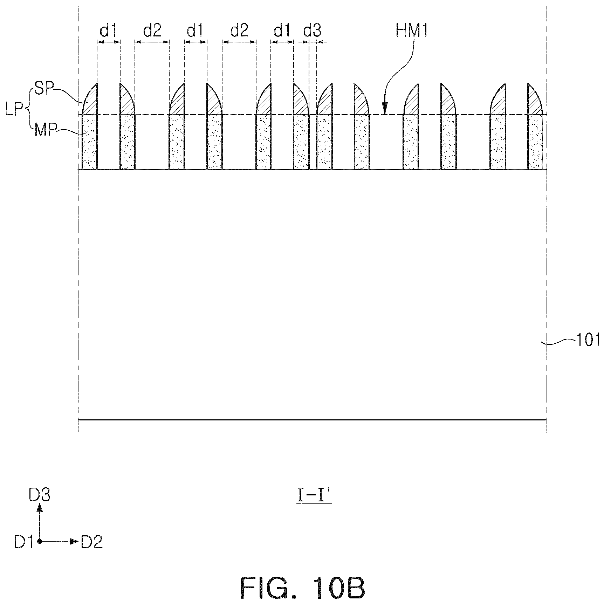

Referring to FIGS. 10A and 10B, a plurality of line patterns LP may be formed on a substrate 101 to extend in parallel in a first direction (for example, D1).

The plurality of line patterns LP may include two groups of line patterns arranged in a second direction (for example, D2), and each group of line patterns LP may include a pair of first line patterns LP1, a pair of second line patterns LP2 disposed on one side of the first line pattern LP1, and a pair of third line patterns LP3 disposed on the other side of the first line pattern LP1.

The plurality of line patterns LP employed in the present embodiment may include a plurality of spacers SP, extending in a first direction (for example, D1), and a mask pattern MP corresponding to the plurality of spacers SP. In an example embodiment, a first hardmask HM1 (denoted by a dashed line) may be formed on the substrate 101, and a self-aligned patterning process may be performed on the first hardmask HM1 in the first direction (for example, D1) to form a plurality of spacers SP, and the first hardmask HM1 may be patterned using the plurality of spacers SP to form line patterns LP including the mask pattern MP and the spacers SP.

The plurality of line patterns LP may be formed to have various shapes under conditions allowed in the self-aligned patterning process. For example, the plurality of spacers may have the same width, and an interval between the plurality of spacers may vary.

In the present embodiment, a distance d1 between the pair of first line patterns LP1 may be substantially the same as a distance d1 between the pair of second line patterns LP2 and a distance d1 between the pair of third line patterns LP3. A distance d2 between adjacent first and second line patterns may be the same as a distance d2 between adjacent first and third line patterns, but may be different from the distance d1 between the first line patterns and a distance d3 between two groups of adjacent line patterns.

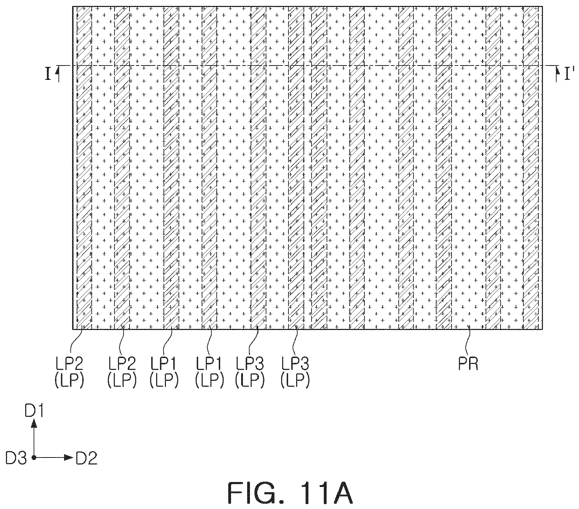

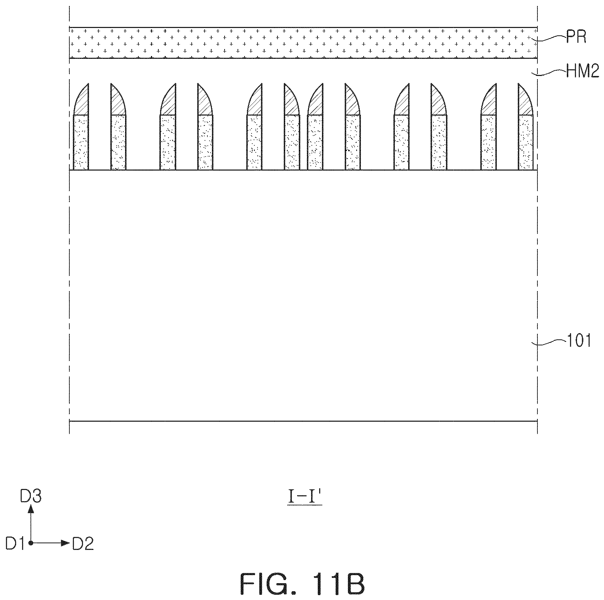

Referring to FIGS. 11A and 11B, a second hardmask HM2 may be formed on the substrate 101 to cover the plurality of line patterns LP, and a photoresist layer PR may be applied to the second hardmask HM2.

In some embodiments, the photoresist layer may be formed of a resist material for extreme ultraviolet (EUV) (for example, 135 nm). In other embodiments, the photoresist layer may be formed of a resist for an F2 excimer laser (157 nm), a resist for an ArF excimer laser (193 nm), or a resist for a KrF excimer laser (248 nm). The photoresist layer may include a positive type photoresist or a negative type photoresist. In some embodiments, a photoresist composition including a photosensitive polymer having an acid-labile group, a potential acid, and a solvent may be spin-coated on the second hardmask HM2 to form a photoresist layer including a positive photoresist.

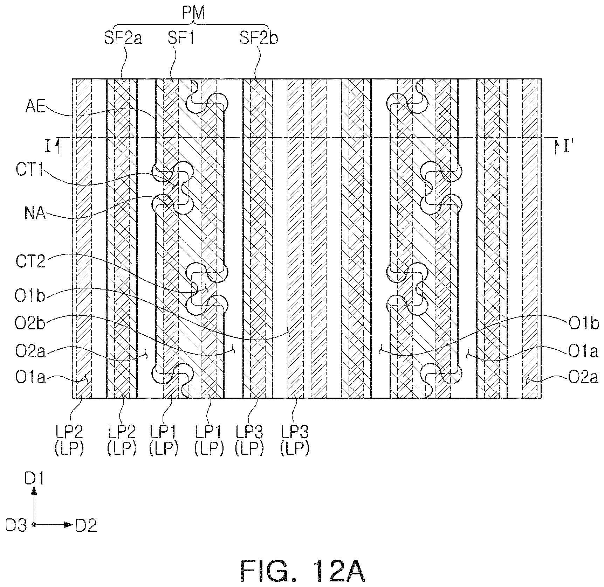

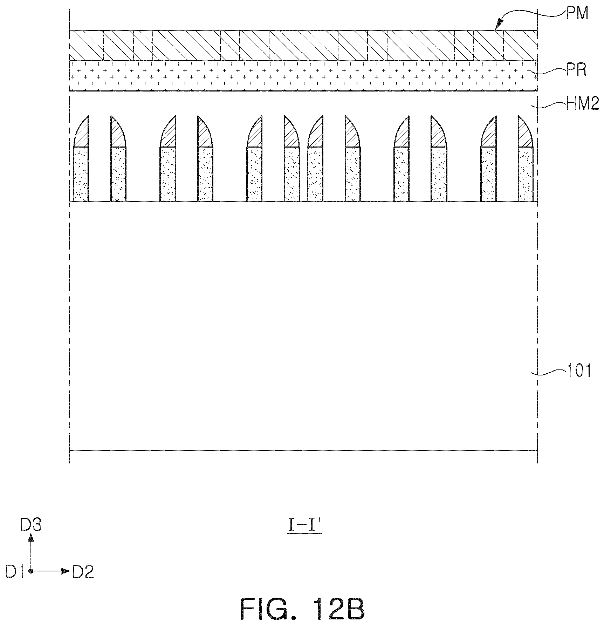

Referring to FIGS. 12A and 12B, a photomask PM for patterning the photoresist layer PR is disposed.

FIG. 18 illustrates a photomask employed in the present process. Referring to FIGS. 12A and 18, the photomask PM employed in the present embodiment may include a first serif portion SF1 and a pair of second serif portions SF2a and SF2b disposed on opposite sides of the first serif portion SF1. The first serif portion SF1 may have a region covering the pair of first line patterns LP1, and may have first and second cut patterns CT1 and CT2 on opposite corners thereof. In the present embodiment, the second serif portions SF2a and SF2b may be formed to cover a single second line pattern LP2 and a single third line pattern LP3, respectively adjacent to the pair of first line patterns LP1.

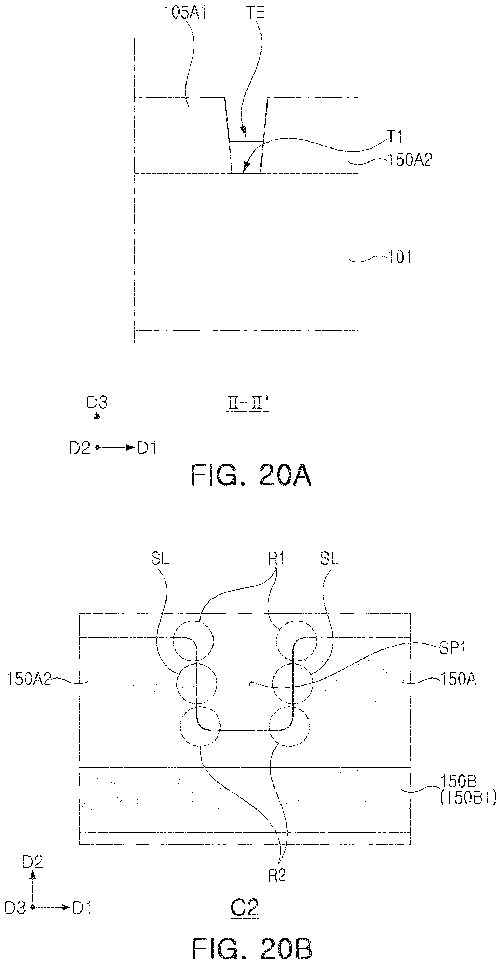

The first and second cut patterns CT1 and CT2 may define first and second notch regions NA1 and NA2 for the first and second separation regions SP1 and SP2 of FIG. 1, respectively. In the present embodiment, a photomask PM may be designed using a hexagonal-corner rounding (H-CR) optical proximity correction (OPC) method to significantly reduce a distortion, so that internal lines of the first and second notch regions NA1 and NA2 may introduce a vertical component ("SL" of FIG. 20B) to address an alignment error issue caused by an unavoidable error of an EUV process (for example, change of a location of an active fin to a direction D2).

An EUV corner rounding improvement or optimization method through H-CR OPC employed in the present embodiment may be described with reference to FIGS. 19A and 19B.

Referring to FIG. 19A, to design a desired rectangular notch region in a virtual mask pattern SF1', a vertex of the notch region may be divided into an internal vertex group (①+②+③) and an external vertex group (⑤+⑥), correction radii Ri and Ro) may be obtained as a correction movement value for each group, and corner rounding may be applied, so that an actual mask pattern SF1 may be implemented as illustrated FIG. 19B. Then, remaining ④ and ⑦ may also satisfy a total edge placement error by improving or optimizing radii in a manner similar to the previous process, and the corner rounding may be further improved or optimized.

Referring to FIG. 19B, the notch region NA1 may have two external corners RC1, convexly rounded by the first radius Ro, and two internal corners RC2 concavely rounded by the second radius Ri. Additionally, the notch region NA1 may have a convexly rounded portion RC3 between the two internal corners RC2.

As described above, a notch region denoted by a dashed line (for example, the cut patterns CT1 and CT2) may be formed using the photomask PM having the optical approximation corrected cut patterns CT1 and CT2 according to the present embodiment.

Referring to FIGS. 13A to 13C, a lithography process using a photomask PM may be performed on the photoresist layer PR to form a photoresist pattern PR'.

The photoresist pattern PR' may include a first pattern PM1, obtained from the first serif portion SF1, and a pair of second patterns PM2a and PM2b obtained from a pair of second serif patterns SF2a and SF2b. The cut patterns CT1 and CT2 formed on the first pattern PM1 may sufficiently secure a vertical component of a side defining a cross-section of an active fin. As described above, inclination of the side of the cross-section by the cut patterns CT1 and CT2 in a second direction (for example, D2) may be significantly reduced to effectively prevent defects (for example, untuck and ghost fin) in which a location of an active fin during an EUV process for the active fin is not accurately aligned with a location of an end of the active fin during formation of a gate line due to an unavoidable error in which the location of the active fin varies in the second direction (for example, D2).

As illustrated in FIG. 12A, widths of the first serif portions SF1 and the second serif portions SF2a and SF2b in the second direction D2 may be designed to be slightly larger than widths of the line patterns LP. Therefore, the photoresist pattern PR' may also be formed such that a portion of the second hardmask HM2 remains on opposite side surfaces of the line patterns LP.

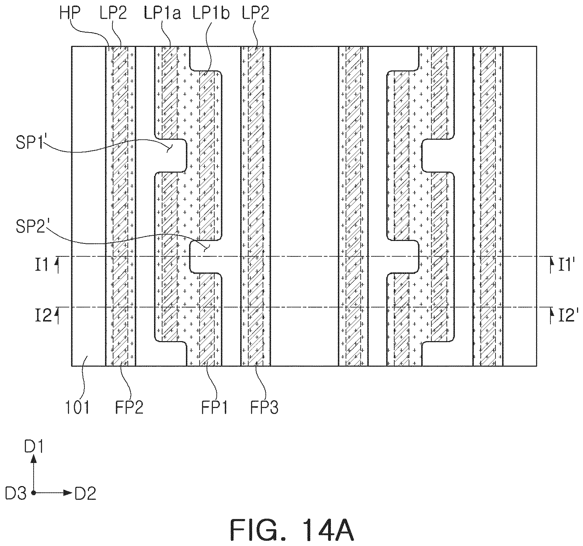

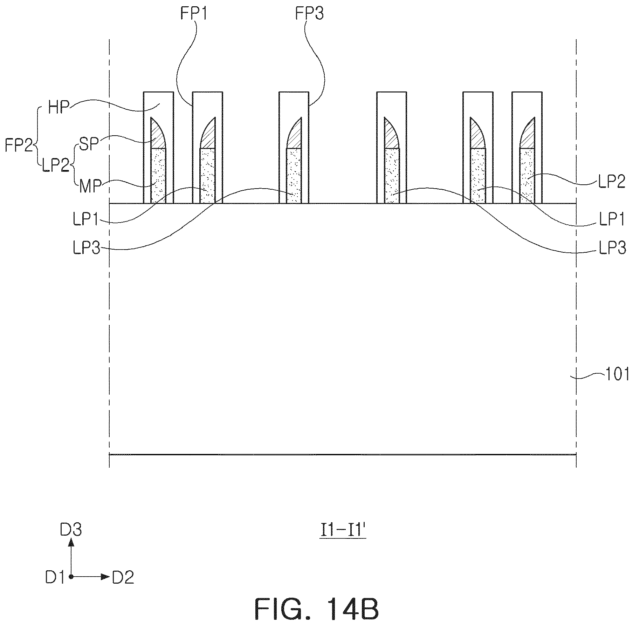

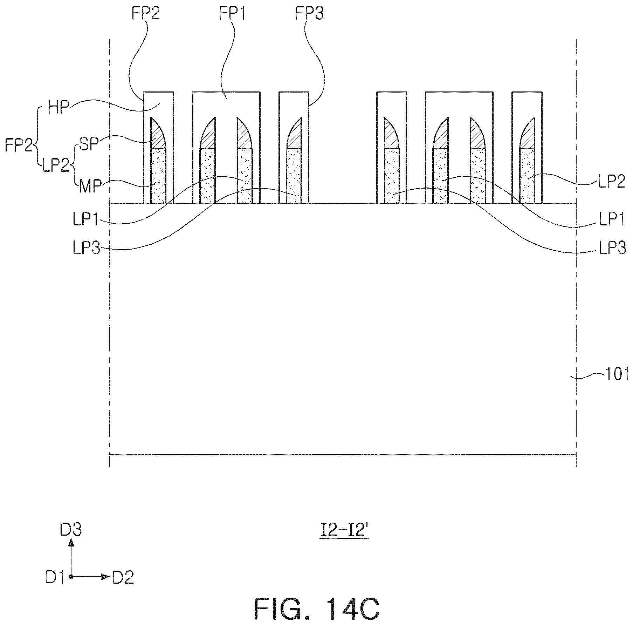

Referring to FIGS. 14A to 14C, a mask pattern FP is formed from the second hardmask HM2 using the photoresist pattern PR', and the photoresist pattern PR' may be removed from the mask pattern FP.

During the formation of the mask pattern FP and the removal of the photoresist pattern PR', a single second line pattern and a single third line pattern disposed in an open region of the photoresist pattern PR' may be removed and a portion, exposed by the cut patterns CT1 and CT2, of a pair of first line patterns may be removed. First and second separation openings SP1' and SP2' may be formed. A pair of first line patterns LP1a and LP1b may be separated into a plurality of (for example, two) patterns by the first and second separation openings SP1' and SP2', respectively.

The remaining mask pattern FP may include the remaining line patterns LP1a, LP1b, LP2, and LP3 and a second hardmask portion HP surrounding the remaining line patterns LP1a, LP1b, LP2, and LP3. In the present embodiment, the mask pattern FP may include a first portion FP1 including a pair of first line patterns LP1a and LP1b, a second portion FP2 covering the remaining second line patterns LP2, and a third portion FP3 covering the remaining third line pattern LP3.

In addition, the mask pattern FP may have a first opening disposed between the first portion FP1 and the second portion FP2, a second opening disposed between the first portion FP1 and the third portion FP3, the first separation opening SP1' extending from the first opening to separate adjacent first line patterns LP1a, and the second separation opening SP2' extending from the second opening to separate adjacent first line patterns LP1b.

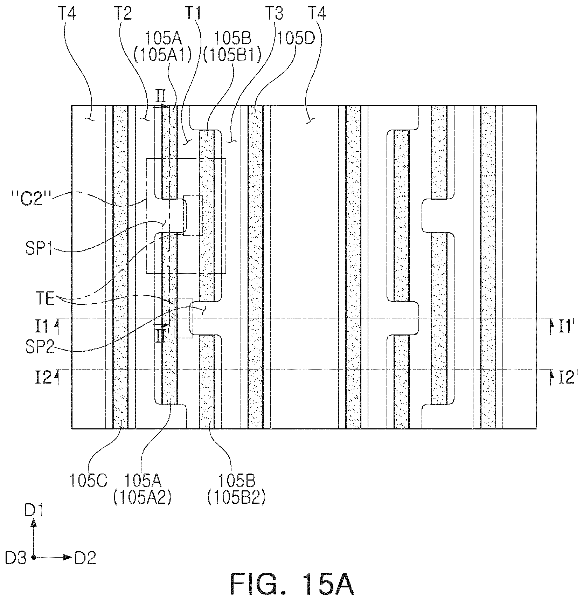

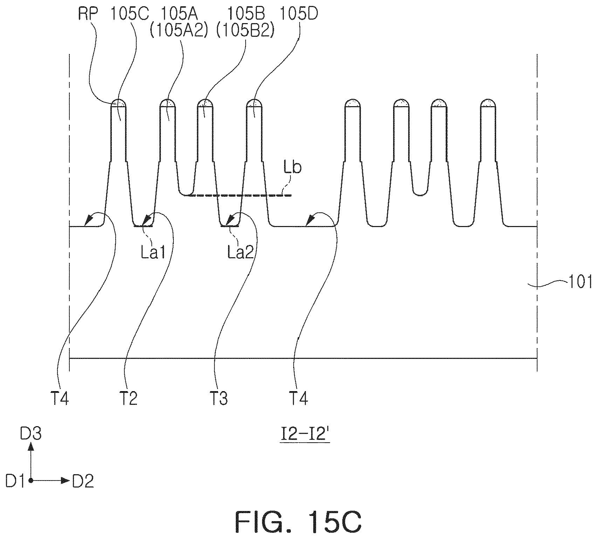

Referring to FIGS. 15A to 15C, the substrate 101 may be etched using the mask pattern MP to form a plurality of active fins 105 extending in the first direction (for example, D1).

The plurality of active fins 105 may include first and second active fins 105A and 105B corresponding to the first portion FP1, a third active fin 105C corresponding to the second portion FP2, and a fourth active fin 105D corresponding to the third portion FP3.

The first active fin 105A may include first and second fin-type patterns 105A1 and 105A2 separated by a first separation region SP1 corresponding to the first separation opening SP1'. Similarly, the second active fin 105B may include first and second fin-type patterns 105B1 and 105B2 separated by a first separation region SP2 corresponding to the second separation opening SP2'.

The first trench region T1 between the first and second active fins 105A and 105B may have a depth, smaller than a depth of each of the other trench regions, for example, the second to fourth trench regions T2, T3, and T4. Since the material of the second hardmask portion HP is present in the first portion FP1 corresponding to a space between the first and second active fins 105A and 105B, the first trench region T1 may be less etched than the other trench regions T2, T3, and T4 to have a relatively small depth. The first to fourth active fins 105A, 105B, 105C, and 105D may have a step structure ST of which a lower region has a width, greater than a width of an upper region due to the second hardmask portion HP.

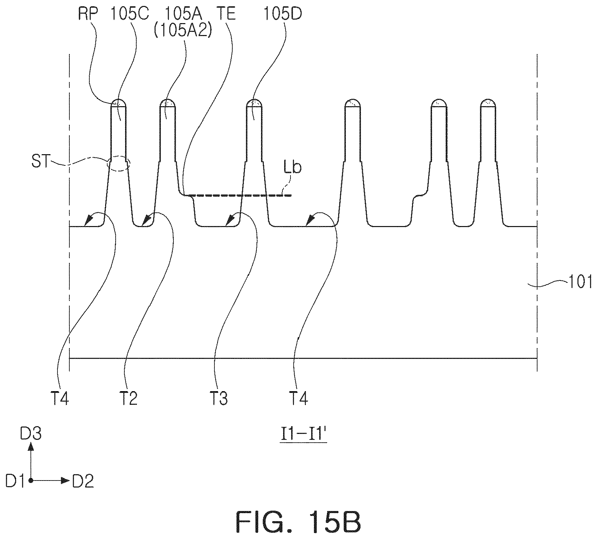

As illustrated in FIG. 15B, a bottom of the first separation region SP1 may have a level La2, substantially the same as a bottom level La1 of the second trench region T2. Similarly, a bottom of the second separation region SP2 may have a level, substantially the same as a bottom level of the third trench region T3. In the present embodiment, the first trench region T1 may have a portion TE extending to the first and second separation regions SP1 and SP2 in the first direction (for example, D1) and defining a step difference relative thereto.

FIG. 20A is a cross-sectional view of FIG. 15A, taken along line 11-11'.

Referring to FIG. 20A together with FIGS. 15A and 15B, the extending portion TE may have a level Lb, higher than a bottom level La2 of each of the first and second separation regions and a bottom level La1 of each of the second to fourth trench regions T2, T3, and T4. A top level Lb of the extending portion TE may be substantially equal to or slightly lower than a bottom level of the first trench region T1.

FIG. 20B is a partially enlarged view of portion "C2" of FIG. 15A.

Referring to FIG. 20B, each of the first fin-type patterns 105A1 and 105A2 may have an end surface defined by the first separation region SP1, and the end surface of each of the first fin-type patterns 105A1 and 105A2 may have a portion SL, substantially perpendicular to the first direction (for example, D1) in plan view. Accordingly, in spite of an error in an EUV process of forming an active fin, one side surface of each of the gate lines GL2 and GL3 of FIG. 3 may be aligned to substantially match the end surface of each of the first fin-type patterns 105A1 and 105A2 provided by the first separation region SP1. Similarly, since a cross-section, defined by the second separation region SP2, of each of the second fin-type patterns 105A1 and 105A2 may have a considerable vertical component, a defect caused by misalignment of a gate line may be prevented.

As illustrated in FIG. 20B, the first and second separation regions SP1 and SP2 have external corners adjacent to the third or fourth active fins and internal corners adjacent to the second active fins, respectively. In plan view, the external corners may have a convexly rounded portion R1, and the internal corners may have a concavely rounded portion R2.

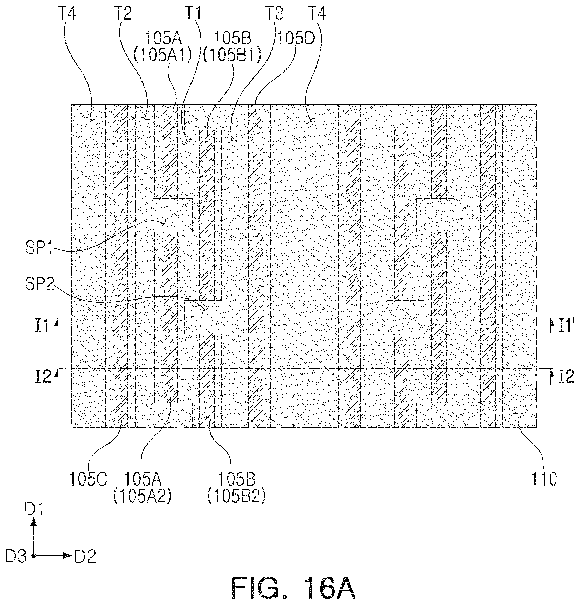

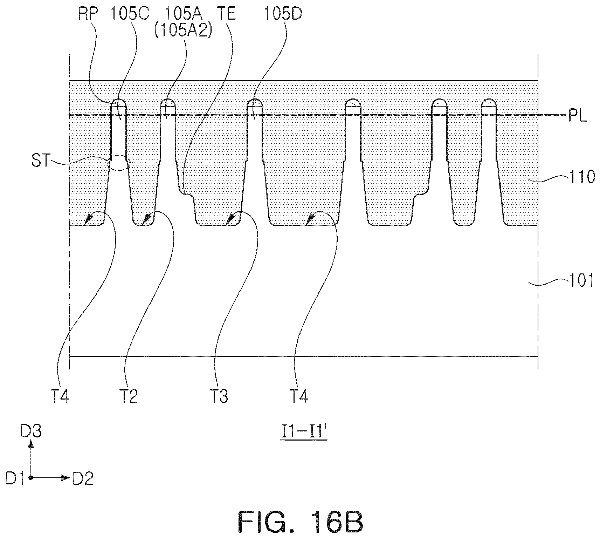

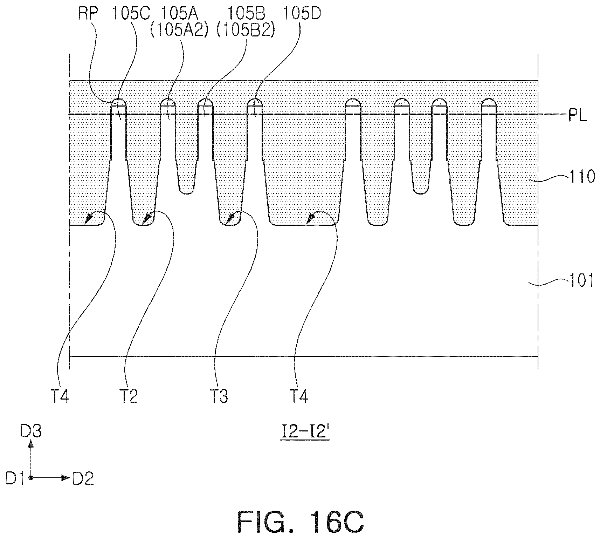

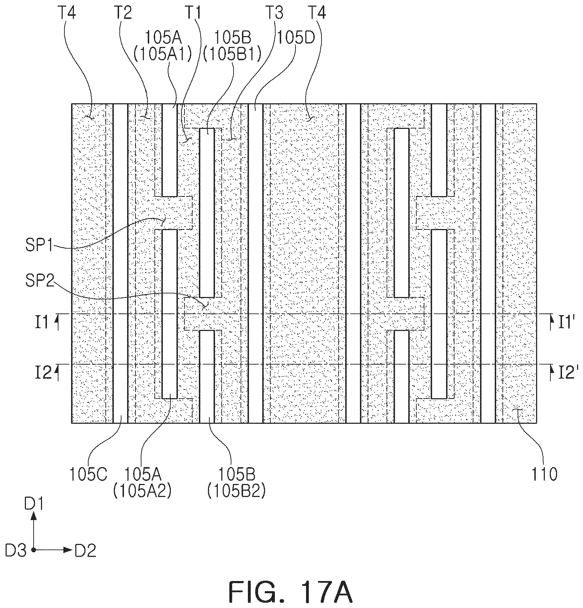

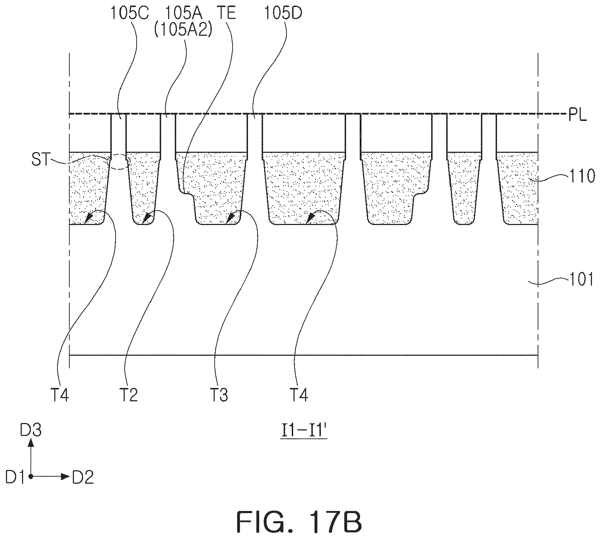

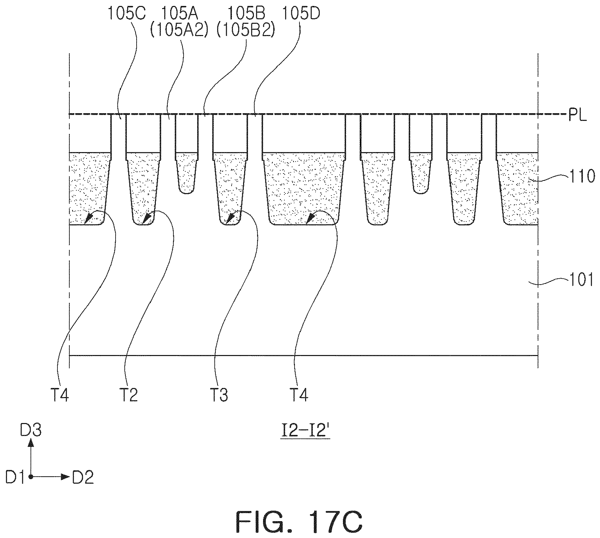

Referring to FIGS. 16A to 16C, a device isolation layer 110 may be formed to cover the plurality of active fins 105, and a planarization process may then be performed to a desired height PL. Referring to FIGS. 17A to 17C, the device isolation layer 110 may be etched back to regions of the plurality of active fins 105 from an upper surface of the device isolation layer 110 to a desired height.

Subsequently, a dummy gate forming process, a source/drain forming process, and a gate line forming process may be additionally performed to fabricate the semiconductor device illustrated in FIGS. 1 to 3.

As described above, a cell having a complex structure (for example, an ultra-high-density SRAM) may be implemented by a simple process (for example, an EUV process performed once) through an active fin forming process using a mask having a notch region. For example, a mask may be designed using a hexagonal-corner rounding (H-CR) optical proximity correction (OPC) method to significantly reduce a distortion, so that an internal line of a notch region may introduce a vertical component to address an alignment error issue caused by an unavoidable error of an EUV process.

While example embodiments have been shown and described above, it will be apparent to those skilled in the art that modifications and variations could be made without departing from the scope of the present inventive concept as defined by the appended claims.

## Claims

1. A semiconductor device comprising:
a first active fin (105A) extending in a first direction (D1) and having first fin-type patterns (105A1, 105A2) aligned with each other with a first separation region (SP1) therebetween;
a second active fin (105B) extending in the first direction (D2) and having second fin-type patterns (105B1, 105B2) aligned with each other with a second separation region (SP2) therebetween, wherein the first and second separation regions (SP1, SP2) are arranged to not overlap each other in a second direction (D2) that intersects the first direction (D1), and wherein a first trench region (T1) between the first and second active fins (105A, 105B) has a first depth (P1);
a third active fin (105C) extending in the first direction (D1) adjacent to the first active fin (105A), wherein a second trench region (T2) between the first and third active fins (105A, 105B) has a second depth (P2) that is greater than the first depth (P1);
a fourth active fin (105D) extending in the first direction (D1) adjacent to the second active fin (105B), wherein a third trench region (T3) between the second and fourth active fins (105B, 105D) has a third depth (P3) that is greater than the first depth (P1);
at least one first gate line (GL1) extending in the second direction (D2) and intersecting the first and second active fins (105A, 105B) and the third active fin (105C); and
at least one second gate line (GL2) extending in the second direction (D2) and intersecting the first and second active fins (105A, 105B) and the fourth active fin (105D),
wherein the first fin-type patterns (105A1, 105A2) and the second fin-type patterns (105B1, 105B2) are merged by the first trench region (T1), and
wherein the second and third trench regions (T2, T3) are connected to the first and second separation regions (SP1, SP2), respectively, and wherein a bottom of the first separation region (SP1) is at a same level as a bottom of the second trench region (T2), and a bottom of the second separation region (SP2) is at a same level as a bottom of the third trench region (T3).

2. The semiconductor device of claim 1, wherein each of the first fin-type patterns (105A1, 105A2) has a first central region, overlapping the second separation region (SP2) in the second direction (D2), and first and second end regions on opposite sides of the first central region, and
wherein each of the second fin-type patterns (105B1, 105B2) has a second central region, overlapping the first separation region (SP1) in the second direction (D2), and third and fourth end regions on opposite sides of the second central region.

3. The semiconductor device of claim 2, wherein the first end region and the fourth end region overlap each other in the second direction (D2) and the second end region and the third end region overlap each other in the second direction (D2).

4. The semiconductor device of claim 3, wherein the at least one first gate line (GL1) comprises a plurality of first gate lines respectively intersecting the third active fin (105C) and the first and fourth end regions overlapping each other, and
wherein the at least one second gate line (GL2) comprises a plurality of second gate lines respectively intersecting the fourth active fin (105D) and the second and third end regions overlapping each other.

5. The semiconductor device of any one of the preceding claims, wherein the first and second active fins (105A, 105B) have a first conductivity type, and the third and fourth active fins (105C, 105D) have a second conductivity type.

6. The semiconductor device of any one of the preceding claims, further comprising:
a third gate line (GL3) extending in the second direction (D2) and aligned with the at least one first gate line (GL1), and intersecting the fourth active fin (105D); and
a fourth gate line (GL4) extending in the second direction (D2) and aligned with the at least one second gate line (GL2), and intersecting the third active fin (105C).

7. The semiconductor device of any one of the preceding claims, wherein the first and second separation regions (SP1, SP2) comprise external corners (adjacent to the third and fourth active fins, respectively, and the external corners comprise a convexly rounded portion (R1) in plan view.

8. The semiconductor device of any one of the preceding claims, wherein the first and second fin-type patterns (105A1, 105A2, 105B1, 105B2) have end surfaces defined by the first and second separation regions (SP1, SP2), respectively, and each of the end surfaces of the first and second fin-type patterns (105A1, 105A2, 105B1, 105B2) has a portion (SL) that is substantially perpendicular to the first direction (D1) in plan view.

9. The semiconductor device of any one of the preceding claims, wherein the first and second separation regions (SP1, SP2) comprise internal corners adjacent to the second and first active fins (105A, 105B), respectively, and the internal corners comprise a concavely rounded portion (R2) in plan view.

10. The semiconductor device of any one of the preceding claims, wherein the first trench region (T1) defines opposing side surfaces of the first and second fin-type patterns (105A1, 105A2, 105B1, 105B2), and comprises a portion (TE) extending to the first or second separation regions (SP1, SP2) in the first direction (D1).

11. The semiconductor device of claim 10, wherein the portion (TE) of the first trench region (T1) has a bottom at substantially a same level as a bottom of the first trench region (T1), which defines a step difference with respect to the bottom of the first or second separation regions (SP1, SP2).

12. The semiconductor device of any one of the preceding claims, wherein the third and fourth active fins (105C, 105D) continuously extend in the first direction (D1) free of a separation region, and a distance between the first and second active fins (105C, 105D) in the second direction (D2) is smaller than a distance between the first and third active fins (105A, 105C) or a distance between the second and fourth active fins (105B, 105D) in the second direction (D2).

13. The semiconductor device of claim 12, wherein the distance between the first and third active fins (105A, 105C) is substantially the same as the distance between the second and fourth active fins (105B, 105D).

14. A method of fabricating a semiconductor device, the method comprising:
forming a plurality of line patterns (LP) on a semiconductor substrate (101) to extend in parallel to each other in a first direction (D1), wherein the plurality of line patterns (LP) comprise first and second line patterns (LP1, LP2) that are adjacent to each other, and a third line pattern (LP3) on one side of the first line pattern (LP1);
forming a hardmask (HM2) on the semiconductor substrate (101) and on the plurality of line patterns (LP);
performing a lithography process using a photomask (PM)on the hardmask (HM2) to form a photoresist pattern (PR');
forming a mask pattern (FP) from the hardmask (HM2) using the photoresist pattern (PR'), wherein the mask pattern (FP) comprises a first portion (FP1) on the first and second line patterns (LP1, LP2), a second portion (FP2) on the third line pattern (LP3), a first opening between the first portion (FP1) and the second portion (FP3), and a second opening extending from the first opening to separate the first line pattern; and
etching the semiconductor substrate (101) using the mask pattern (FP) to form a plurality of active fins (105A, 105B, 105C, 105D) extending in the first direction (D1).

15. The method of claim 14, wherein the photomask (PM) comprises a first serif portion (SF1), corresponding to the first portion (FP1) and having a notch pattern corresponding to the second opening in one side corner, and a second serif portion (SF2a) corresponding to the second portion (FP2),
wherein the notch pattern has two external corners (RC1), convexly rounded by a first radius, and two internal corners (RC2) concavely rounded by a second radius, and
wherein the first radius and the second radius are provided by optical proximity correction.
